(19) Europäisches Patentamt European Patent Office Office européen des brevets

(11) **EP 1 501 131 B1**

(12) **EUROPEAN PATENT SPECIFICATION**

(45) Date of publication and mention
of the grant of the patent:
**19.05.2010 Bulletin 2010/20**

(51) Int Cl.:
*H01L 31/0224* (2006.01)   *H01L 31/18* (2006.01)
*H01L 31/075* (2006.01)

(21) Application number: **04010786.4**

(22) Date of filing: **06.05.2004**

(54) **Stacked photovoltaic element and production method thereof**

Gestapeltes photovoltaisches Bauelement und Herstellungsverfahren

Dispositif photovoltaique empilé et méthode de fabrication

(84) Designated Contracting States:
**AT BE BG CH CY CZ DE DK EE ES FI FR GB GR HU IE IT LI LU MC NL PL PT RO SE SI SK TR**

(30) Priority: **08.05.2003 JP 2003130168**
**13.04.2004 JP 2004117671**

(43) Date of publication of application:
**26.01.2005 Bulletin 2005/04**

(73) Proprietor: **CANON KABUSHIKI KAISHA
Tokyo (JP)**

(72) Inventors:
• **Nakayama, Akiya
Ohta-ku
Tokyo (JP)**
• **Tamura, Hideo
Ohta-ku
Tokyo (JP)**
• **Takai, Yasuyoshi
Ohta-ku
Tokyo (JP)**

(74) Representative: **TBK-Patent
Bavariaring 4-6
80336 München (DE)**

(56) References cited:
**EP-A- 0 698 929     EP-A- 1 168 458
US-A- 5 417 770**

• **ZHANG KERAN ET AL: "Effect of hydrogen partial pressure on optoelectronic properties of indium tin oxide thin films deposited by radio frequency magnetron sputtering method" JOURNAL OF APPLIED PHYSICS, AMERICAN INSTITUTE OF PHYSICS. NEW YORK, US, vol. 86, no. 2, 15 July 1999 (1999-07-15), pages 974-980, XP012048295 ISSN: 0021-8979**

**Description**

BACKGROUND OF THE INVENTION

Field of the Invention

The present invention relates to a stacked photovoltaic element comprising a transparent electrode provided on the surface of a light incident side of stacked unit elements.

Related Background Art

Heretofore, in general, importance has been given to the fact that a transparent conductive film stacked on a photovoltaic element has a high transmittivity and a low resistance. If the transparent electrode stacked on the incident light side has a high transmittivity, a light utilizable in a semiconductor layer is increased to improve a short-circuit current (Jsc), and if it has a low resistance, a current loss is little, thereby improving an efficiency of photoelectric conversion.

One of the materials used widely in such a transparent electrode is ITO (Indium Tin Oxide). For example, Japanese Patent Application Laid-Open No. 2001-152323 (no family patent application available except for Japan) discloses that an ITO target having Sn content of 2, 5 and 10 wt% is used for a sputtering method, and that a film having a high transmittivity and a low resistance can be formed by using the ITO target for obtaining a high transmittivity up to a long-wavelength light most suitable for the stacked photovoltaic element, while changing a He flow rate.

Further, Japanese Patent No. 2999280 (U.S. Patent 5279679, EP 509215 B1) discloses that a sheet resistance value of the transparent electrode of the stacked photovoltaic element having a triple constitution in which three unit elements each having a pin constitution are stacked is $100\Omega/\square$ or less.

It is known that, in the ITO simple film, if a temperature for film formation is set to a high temperature of about 400°C, a film quality having a high transmittivity and a low resistance is obtained, and a resistance is changed by an oxygen flow rate.

In general, the characteristics required for the transparent electrode of a solar cell are a high transmittivity and a low resistance. On the other hand, the transmittivity and the resistance of the ITO are in an incompatible relation, and the ITO single film has been used so far in combination with the stacked photovoltaic element on the condition that the transmittivity and the resistance are compatible at a level as high as possible as the characteristics of the ITO single film, and when considering a total balance of the element, the conventional characteristics are not most suitable. Consequently, when considering the combination with the stacked photovoltaic element, the characteristics are not most suitable, and they have not been sufficiently reviewed.

The ITO suitable for use of the transparent electrode of the solar cell is desired to be high in a transmittivity in order to allow a light to be absorbed more into a semiconductor layer, and low in a resistance in order to collect a carrier generated by a power generation, as described above. Particularly, the stacked photovoltaic element comprising hydrogenated amorphous silicon, hydrogenated amorphous silicon germanium, hydrogenated amorphous silicon carbide, microcrystalline silicon, polycrystalline silicon or the like is desired to have a high transmittivity up to a long wavelength and have the most adequate characteristics of a resistance.

Further, consideration has to be given to the fact that the product such as the solar cell is used for a long period of time, and in view of the durability of the ITO, it is necessary to form an ITO excellent in adhesiveness with an underlying layer. Further, for the popularization of the solar cell, it is necessary to reduce the production cost, and the apparatus for producing the ITO is required to be inexpensive and simple.

However, in the existing circumstances, an ideal ITO to satisfy these characteristics entirely has not yet been obtained.

Document US 5,417,770 discloses a method of quickly depositing a non-single-crystal semiconductor film and forming a silicon-type non-single crystal photovoltaic device. It is provided a photovoltaic device comprising: a p-type layer, an i-type layer, and an n-type layer made of silicon non-single-crystal semiconductor material.

Document EP 0 698 929 A2 discloses a photovoltaic element excellent in characteristics such as a conversion efficiency, and a process for fabricating it. The back reflector layer has a first metal of alloy, and a transparent oxide of a second metal formed on the first metal or alloy.

SUMMARY OF THE INVENTION

Thus, the object of the present invention is to solve the above-described problem, form an optimum ITO as a transparent electrode particularly in combination with a stacked photovoltaic element, and realize a stacked photovoltaic element having an excellent photoelectric conversion efficiency with a high reliability which can be produced at a low cost.

The present inventors did not aim at an optimization of each of the photovoltaic element and the transparent electrode, but their attentions were paid to a most adequate balance in the whole element constitution including the photovoltaic element and the transparent electrode. In order to make high characteristics and a high stability compatible, they paid their attentions to and studied extensively on particularly a relationship between the constitution of a stacked photovoltaic element and the film quality due to an amount of $SnO_2$ contained in the ITO target, an amount of oxygen in a gas introduced in film formation and the like. As a result, in the case where the number of stacked layers in the stacked photovoltaic element was increased, since according to the increase in the number of stacked layers, the current of a unit element became small and particularly, the current of the unit element on a long wavelength side became small, and thereby the short-circuit current (Jsc) became small, the present inventors found that as for the film quality of the ITO, particularly a light transmittivity preceded in order to predominantly improve the current by increasing the utilization efficiency of the incident light up to a long wavelength, while as for the resistance, an ITO having a resistance as low as possible within the limited range was most appropriate. The present inventors have completed the following invention.

That is, the present invention provides a stacked photovoltaic element, according to claim 1.

The stacked photovoltaic element of the present invention further has the following features.

The current value of the unit element having the smallest current in the light collective efficiency measurement is preferably 12 mA/cm$^2$ or less.

The stacked photovoltaic element preferably has a construction in which three unit elements each having a pin constitution are stacked (triple construction).

The stacked photovoltaic element preferably has a construction in which two unit elements each having a pin constitution are stacked (double construction).

The transparent electrode is preferably formed by deposition using the ITO target having $SnO_2$ content of 0.5 wt% or more and 4 wt% or less.

Further, the present invention provides a method of producing a stacked photovoltaic element. according to claim 6.

Further details are set forth in the dependent claim.

BRIEF DESCRIPTION OF THE DRAWINGS

FIG. 1 is a cross-sectional view schematically showing one example of a stacked photovoltaic element of the present invention;

FIG. 2 is a schematic illustration of a preferable sputtering apparatus as an apparatus for producing a transparent electrode (ITO) of the present invention;

FIG. 3 is a cross-sectional view schematically showing a sample substrate of a triple construction used in Example 1;

FIG. 4 is a cross-sectional view schematically showing a sample substrate of a double construction used in Example 2;

FIG. 5 is a graph for graphically representing Table 1 showing the estimation results of the stacked photovoltaic element produced in Example 1;

FIG. 6 is a graph for graphically representing Table 2 showing the estimation results of the stacked photovoltaic element produced in Example 1;

FIG. 7 is a graph showing the results of a light collection efficiency measurement and the photoelectric conversion efficiency of the stacked photovoltaic element produced in Example 1;

FIG. 8 is a graph showing the measurement results of a transimmissivity of the stacked photovoltaic element produced in Example 1; and

FIG. 9 is a graph showing the estimation results of a transimmissivity of the stacked photovoltaic element produced in Example 2.

DESCRIPTION OF THE PREFERRED EMBODIMENTS

The embodiments of the present invention will be described below, but it will be appreciated that the present invention is not limited to these embodiments.

The stacked photovoltaic element of the present invention includes a stack formed of a plurality of simple elements each having a pin constitution, and a transparent electrode comprising an ITO provided on the surface of an incident plane side of these stacked unit elements.

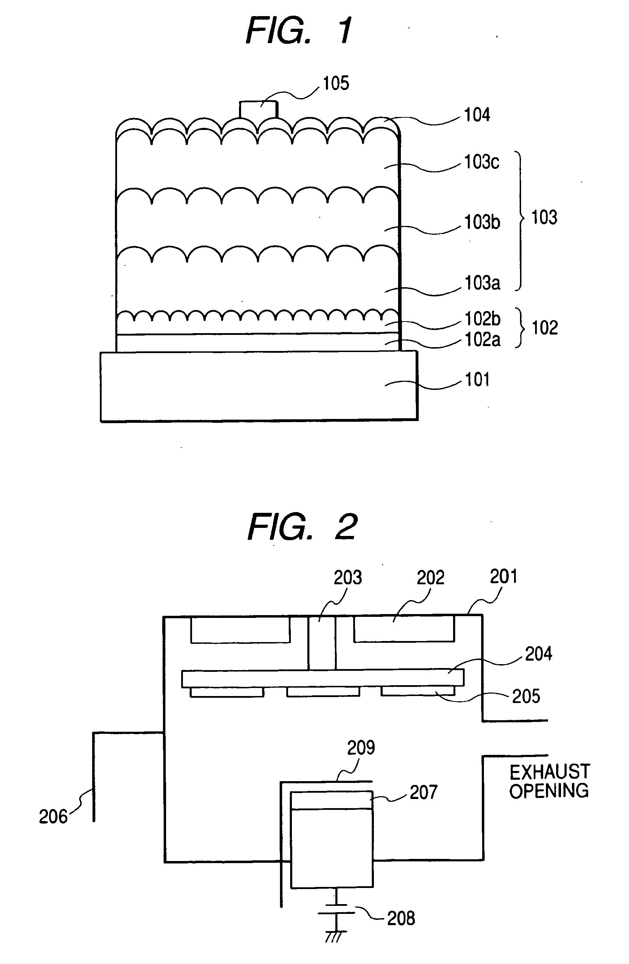

FIG. 1 is a cross-sectional view showing one example of the stacked photovoltaic element of the present invention, which comprises on an underlying substrate 101, a back surface reflection layer 102 (reflection film 102a and transparent conductive layer 102b), a semiconductor layer 103 (bottom cell 103a, middle cell 103b and top cell 103c), a transparent electrode 104 and a collecting electrode 105 which are stacked in mentioned order.

The materials for the underlying substrate 101 include any one of a conductive or insulating material. An insulating substrate having a surface subjected to a conductive property imparting treatment may be used. A semiconductor crystal bulk may be used. Further, a transparent material such as a glass and the like may be used, but a preferable material is a material having little deformation and distortion and a desired strength, which is a metal such as Fe, Ni, Cr, Al and the like or an alloy made of them, a thin plate such as stainless steel and the like and a composite thereof, and a film of heat-resistant synthetic resin such as polyester and polyethylene, and the like.

The back surface reflection layer 102 (reflection layer 102a and transparent conductive layer 102b) plays a role of increasing a short-circuit current (Jsc) of the photovoltaic element by allowing a light not sufficiently absorbed by the semiconductor layer 103 to reflect again on the semiconductor layer. Further, by making the surfaces of the transparent conductive film 102b and/or the reflection film 102a into an irregular shape, the light is irregularly reflected, so that a light path length inside the semiconductor layer can be extended and the short-circuit current (Jsc) can be further increased. Hence, for the reflection film 102a of the back surface reflection layer, a material having a high reflectivity such as Al, Ag and the like is preferable, and for the transparent conductive film 102b of the back surface reflection layer, an inexpensive material capable of easily obtaining the irregular shape such as ZnO and the like is preferable. Further, the back surface reflection layer 102 may serve also as the other electrode of the photovoltaic element.

The semiconductor layer 103 comprises stacked three unit elements (bottom cell 103a, middle cell 103b and top cell 103c) each having a pin constitution, and makes it possible to effectively utilize a light of wavelength 300 to 1200 nm.

The transparent electrode 104 comprises an ITO, and, for example, is produced by using a sputtering apparatus as shown in FIG. 2. In the drawing, reference numeral 201 denotes a film formation chamber, reference numeral 202 a heater, reference numeral 203 a rotating shaft, reference numeral 204 a substrate holder, reference numeral 205 a sample substrate, reference numeral 206 a gas supply line, reference numeral 207 an ITO target, reference numeral 208 a power source, and reference numeral 209 a shutter. Hereinafter, the formation procedures of the transparent electrode 104 using this apparatus will be described.

(1) A sample substrate 205 is set on the substrate holder 204, and the film formation chamber 201 is vacuum-exhausted by a vacuum pump (not shown). Incidentally, the sample substrate 205 has a construction in which the back surface reflection layer 102 (reflection film 102a and transparent conductive film 102b) and the stacked conductive layer 103 are stacked on the underlying substrate 101, shown in FIG. 1, by another deposition apparatus.
(2) After the film formation chamber 201 has been vacuum-exhausted up to a predetermined pressure, a raw material gas feeding device (not shown) supplies an argon gas and an oxygen gas from a gas supply line 206, and adjusts an opening of an unillustrated exhaust valve so as to be adjusted to a predetermined pressure.
(3) The substrate holder 204 is rotated by the rotating shaft 203.
(4) Next, the heater 202 is set to become a formation temperature of the transparent electrode (ITO), and when the temperature of the heater becomes the predetermined temperature, the DC power source 208 is turned on, and argon gas plasma is generated, and the shutter 209 is opened, and the transparent electrode 104 is deposited. When the transparent electrode is deposited at a predetermined film formation speed by a predetermined thickness, the shutter 209 is closed, and the DC power source 208 is turned off.

By doing so as described above, a sample having the stacked transparent electrode 104 is taken out of the apparatus, and by forming the collecting electrode 105 on this transparent electrode, the stacked photovoltaic element as shown in FIG. 1 is produced.

As described above, the transmittivity and sheet resistance of the ITO used for the transparent electrode 104 are in an incompatible relation, and when the content of $SnO_2$ is reduced to enhance the transmittivity, the sheet resistance becomes too high and thereby a photoelectric conversion efficiency is lowered in a photoelectric conversion element in which a large amount of current flows. Therefore, it is not possible to utilize the ITO in the prior art.

The present inventors found the following:

(1) With respect to the stacked photovoltaic element comprising a stack formed of a plurality of unit elements each having a pin constitution, since the current becomes smaller as the number of stacked layers increases, the influence of the sheet resistance of the transparent electrode, which is a cause of lowering the photoelectric conversion efficiency, becomes small, and the use of the transparent electrode having a higher sheet resistance is made possible, and
(2) The use of the transparent electrode having a higher transmittivity in a wide wavelength range of 300 to 1200 nm, particularly the use of the transparent electrode having a higher transmittivity in the maximum absorption wavelength of a unit element having the smallest current in a light collection efficiency measurement among a plurality of unit elements constituting the stacked photovoltaic element, is extremely important for enhancing the photoelectric conversion efficiency.

Specifically, in order to improve the transmittivity of a long wavelength, the content of $SnO_2$ is set to be small, preferably 0.5 %wt or more and 4 %wt or less, and more preferably 0.5 %wt more and 2 %wt or less so as to attempt the improvement of the transmittivity by reducing a carrier density, and at the same time, it is preferable that, by adjusting of oxygen of a feed gas and a water vapor gas volume at the time of an ITO film formation and the like, the sheet resistance is optimized.

According to the study of the present inventors, it has become clear that the ITO used for the transparent electrode 104 was designed such that the transmittivity of light of the maximum absorption wavelength of a unit element (typically bottom cell) having the smallest current in a light collection efficiency measurement was 90% or more and 99.8% or less, and the sheet resistance was 120Ω/□ or more and 220Ω/□ or less, whereby the photoelectric conversion efficiency of the stacked photovoltaic element could be effectively improved. With respect to the above-described transmittivity, the transmittivity is preferably 95.0% or more and 99.8% or less, and particularly the transmittivity is preferably 98.5% or more and 99.8% or less. Further, with respect to the sheet resistance, as shown in the following example, a more preferable range is varied depending on whether the stacked photovoltaic element has a double constitution or a triple constitution. In the case of the stacked photovoltaic element having a triple constitution, the sheet resistance can be 80Ω/□ or more and 250Ω/□ or less, and the sheet resistance, for the invention is 120Ω/□ or more and 220Ω/□ or less. In the case of the stacked photovoltaic element having a double constitution, the sheet resistance is 120Ω/□ or more and 220Ω/□ or less.

Further, the current value of a unit element having the smallest current in the light collection efficiency measurement is preferably 12 mA/cm$^2$ or less, and in this way, a large effect by the ITO of the present invention can be expected.

Further, the thickness of the ITO used for the transparent electrode 104 is preferably 60 nm or more and 70 nm or less. In this way, it is possible to control the reflectivity to a low level and attempt further improvement of the photoelectric conversion efficiency.

Incidentally, the forming conditions of the semiconductor layer 103 preferably are the substrate temperature of the deposition chamber of 100 to 450°C, the pressure of 500 Pa (3.75 Torr) to 2666 Pa (20 Torr), and a high frequency power density of 300 mW/cm$^3$ (input power/deposition chamber volume).

A source gas suitable for the formation of a silicon-based semiconductor layer and the semiconductor layer 103 includes a gasifiable compound containing a silicon atom such as $SiH_4$, $Si_2H_6$ and the like, and a halogenated silicon such as $SiF_4$, $Si_2F_6$, $SiH_2F_2$, $SiH_2Cl_2$, $SiCl_4$, $Si_2Cl_6$ and the like are cited. The gas vaporized at normal temperatures is used by a gas cylinder, and the gas liquefied is used by performing a bubbling by an inert gas. In case of forming an alloy-based layer, it is desirable that the gasifiable compound containing Ge and C such as $GeH_4$ and $CH_4$ is added to the source gas. It is desirable that the source gas is introduced into the deposition chamber by attenuating it by a dilution gas. The dilution gas includes $H_2$, He and the like. Further, the gasifiable compound containing nitrogen, oxygen and the like may be added as the source gas or the dilution gas. A dopant gas for converting the semiconductor layer into a p-type layer includes $B_2H_6$, $BF_3$ and the like. Further, a dopant gas for converting the semiconductor layer into a n-type layer includes $PH_3$, $PF_3$ and the like. In the case where a crystal phase semiconductor and a layer having little light absorption such as SiC or having a wide band gap are deposited, it is preferable that a ratio of the dilution gas to the source gas is increased and a high frequency of a relatively high power density is introduced. In the case of the triple constitution, the combination of an i-type silicon-based semiconductor layer includes, from the light incident side, (the amorphous semiconductor layer, the amorphous semiconductor layer, and the semiconductor layer including a crystal phase), (the amorphous, the semiconductor layer including the crystal phase, and the semiconductor layer including the crystal) and (the semiconductor layer including the crystal phase, the semiconductor layer including the crystal phase and the semiconductor layer including the crystal phase), and in the case of the double constitution, the combination of an i-type silicon-based semiconductor layer includes, from the light incident side, (the amorphous semiconductor layer and the semiconductor layer including the crystal phase), (the semiconductor layer including the crystal phase and the semiconductor layer including the crystal phase). The i-type semiconductor layer preferably has an absorption efficiency ($\alpha$) of the light (630 nm) of 5000 cm$^{-1}$ or more, a photoconductivity of $10 \times 10^{-5}$ S/cm or more under a pseudo sunlight irradiation by a solar simulator (AM 1.5, 100 mW/cm$^2$), a dark conductivity ($\sigma d$) of $10 \times 10^{-6}$ S/cm or less, and the Urback energy by a constant photo current method (CPM) of 55 meV or less. The i-type semiconductor layer which is slightly made p-type or n-type can be used.

Although the examples of the present invention will be described below, it will be appreciated that the present invention is not limited to these examples.

(Example 1)

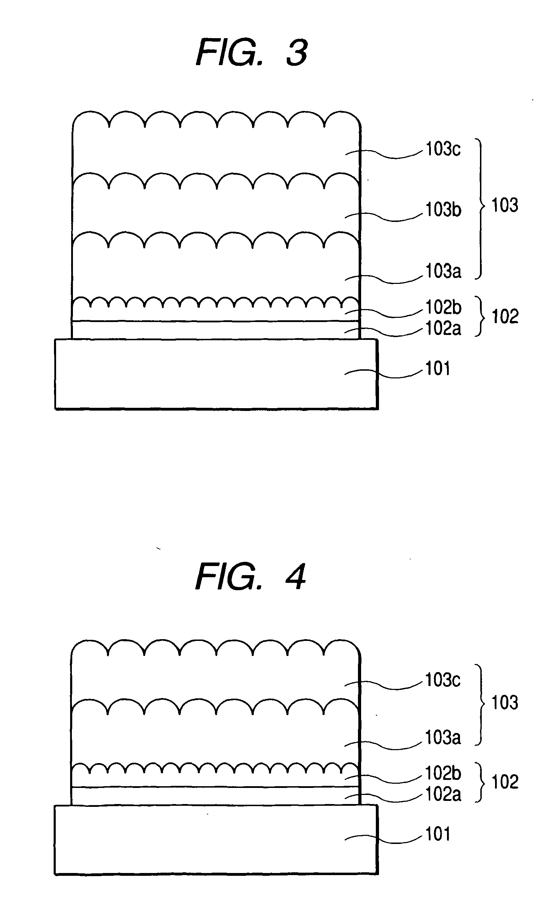

A transparent electrode (ITO) was formed on the sample substrate of a triple constitution shown in FIG. 3 by using an apparatus shown in FIG. 2. In the present example, the substrate temperature was set to 200°C, and the ITO targets having five different $SnO_2$ content of 0.5 wt%, 1 wt%, 3 wt%, 5 wt% and 10 wt% were used. Incidentally, at the film formation time of the ITO, the gases of argon, oxygen, and water vapor were supplied, and the feed rate of vapor was adjusted as a parameter for changing a sheet resistance.

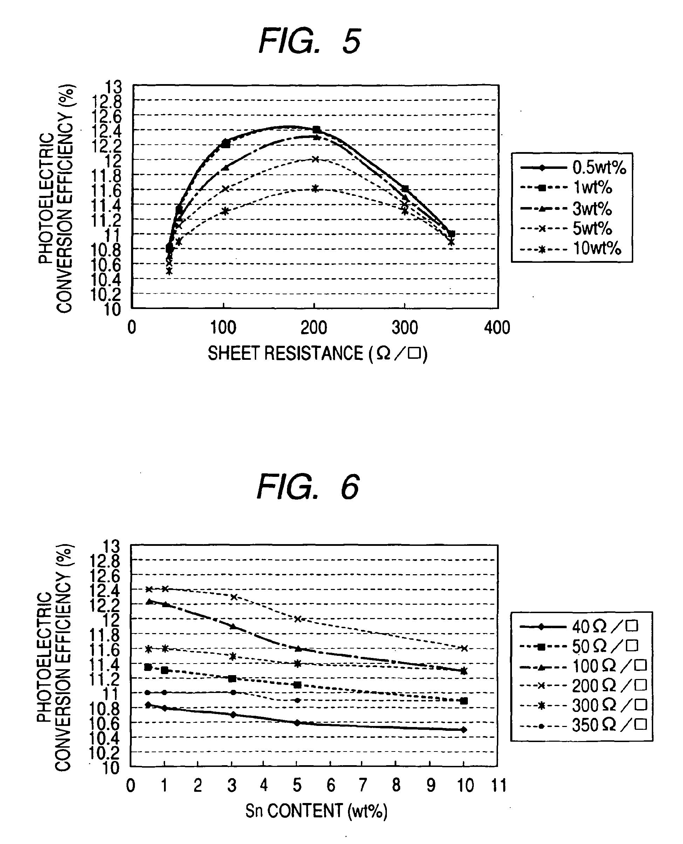

The initial characteristics of the photoelectric conversion efficiency of the stacked photovoltaic element produced as described above were estimated by using the solar simulator (AM 1.5, 100 mW/cm$^2$, and the surface temperature 25°C). The result (photoelectric conversion efficiency: unit is %) is shown in Tables 1 and 2, and FIGS. 5 and 6. Incidentally, FIG. 5 is a graphic presentation of Table 1, and FIG. 6 is a graphic presentation of Table 2.

From these tables and figures, particularly FIG. 5, a suitable range of the sheet resistance of the transparent electrode used for the stacked photovoltaic element of a triple constitution can be derived. To be more precise, it is 120Ω/□ or more and 220Ω/□ or less.

Further, the suitable range of the content of tin in the case where the transparent electrode comprising the ITO is formed by a sputtering method can be derived. To be more precise, it will be appreciated that the range is preferably 0.5 wt% or more and 4 %wt or less, and more preferably 0.5 %wt or more and 2 %wt or less.

Table 1

| | | SnO$_2$ content of the target (wt%) | | | | |
|---|---|---|---|---|---|---|
| | | 0.5 | 1 | 3 | 5 | 10 |
| Sheet resistance of ITO (Ω/□) | 40 | 10.85 | 10.8 | 10.7 | 10.6 | 10.5 |
| | 50 | 11.35 | 11.3 | 11.2 | 11.1 | 10.9 |
| | 100 | 12.25 | 12.2 | 11.9 | 11.6 | 11.3 |
| | 200 | 12.4 | 12.4 | 12.3 | 12 | 11.6 |
| | 300 | 11.6 | 11.6 | 11.5 | 11.4 | 11.3 |
| | 350 | 11 | 11 | 11 | 10.9 | 10.9 |

Table 2

| | | SnO$_2$ content of the target (wt%) | | | | |
|---|---|---|---|---|---|---|
| | | 0.5 | 1 | 3 | 5 | 10 |
| Sheet resistance of ITO (Ω/□) | 50 | 11.2 | 11.2 | 11.1 | 10.9 | 10.7 |
| | 100 | 11.73 | 11.7 | 11.6 | 11.4 | 11.2 |
| | 200 | 11.1 | 11.1 | 11 | 10.9 | 10.6 |
| | 300 | 10.5 | 10.5 | 10.4 | 10.3 | 10.2 |
| | 350 | 10 | 10 | 10 | 9.9 | 9.7 |

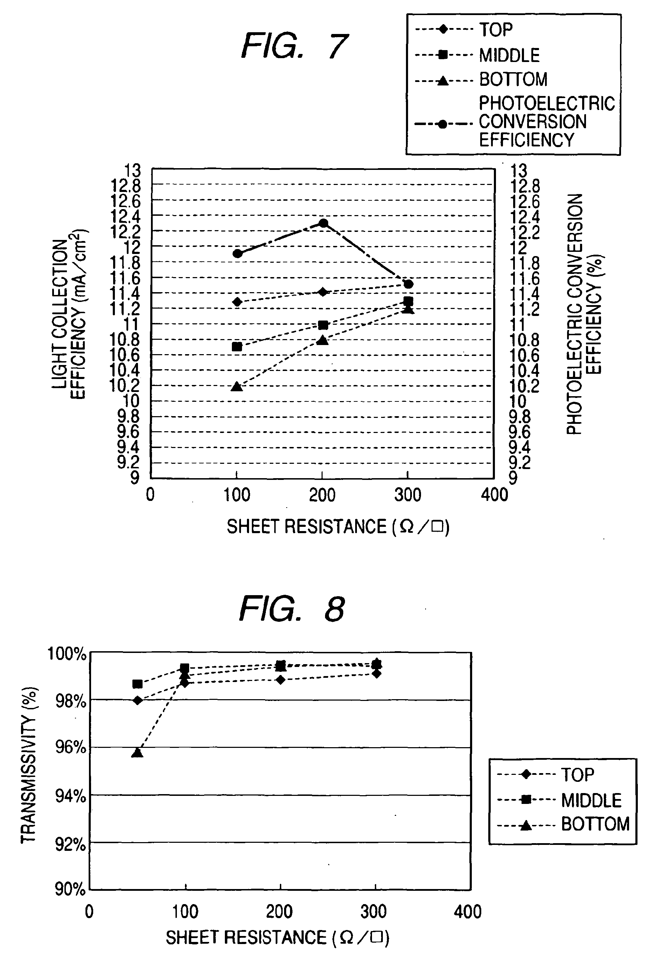

Next, to estimate the absorption of the light by which the transparent electrode contributes to a collecting current, the current of each stacked semiconductor layer was estimated not by the Jsc itself, but by a light collection efficiency measurement (Q curve measurement: the measuring method was carried out according to the method disclosed in the foreign application corresponding to Japanese Patent Application No. 2002-328999 and the present application). As a result, the stacked photovoltaic element of the triple constitution of the present embodiment was 10 to 12 mA/cm$^2$ in current of the unit element. FIG. 7 shows a result of the light collection efficiency measurement (of the top, middle and bottom cells) and the photoelectric conversion efficiency of the stacked photovoltaic element of the triple constitution in which the transparent electrode was formed by using the ITO target having the SnO$_2$ content of 3 wt%.

As shown in FIG. 7, the unit element having the smallest current in the light collection efficiency measurement was the bottom cell in either case. Incidentally, the stacked photovoltaic element of the triple constitution produced using the ITO target, in which the transparent electrode was formed using the ITO target having the SnO$_2$ content of 0.5 wt%, 1 wt%, 5 wt%, and 10 wt%, showed the same tendency.

From the above-described result, it is evident that the improvement of the photoelectric conversion efficiency can be attempted by adjusting the SnO$_2$ content of the ITO target and the feed rate of water vapor, and then, adjusting the sheet resistance. Further, according to the result of Fig. 7, it is understood that the improvement of the current of the bottom cell having the smallest current in the light collection efficiency measurement largely contributes to the photoelectric conversion efficiency in the vicinity of the sheet resistance 200Ω/□. The reason why the photoelectric conversion efficiency is low despite of high light collection efficiency at the sheet resistance of 300Ω/□ is considered that the influence by the increase of the resistance in the ITO exceeds the influence by the improvement of the light collection efficiency.

Next, the transparent electrode (ITO) was formed by using the apparatus shown in FIG. 2 on a glass substrate (#7059 made by Corning Inc.) similarly as above. Here, the ITO targets having two $SnO_2$ content of 3 wt% and 10 wt% were used, and the substrate temperature was set to 200°C similarly as above. At the film formation time of the ITO, argon gas, oxygen gas and water vapor were supplied, and the feed rate of the vapor was adjusted as a parameter for changing the sheet resistance.

The transmittivity of the transparent electrode (ITO) formed as described above was measured by using a spectrophotometer. The transmittivity was calculated by using the following formula:

$$\texttt{Transmittivity = a/(1 -(b - C))}$$

   a: ITO transmittivity on a glass
   b: ITO reflectivity on a glass
   c: Single glass reflectivity

The result of the transmittivity of the transparent electrode (ITO) calculated as described above is shown in FIG. 8. In FIG. 8, "TOP" (top cell) shows a transmittivity of 500 nm, "MIDDLE"' (middle cell) shows a transmittivity of 650 nm, and "BOTTTOM" (bottom cell) shows a transmittivity of 750 nm. The wavelength 500 nm corresponds to the maximum absorption wavelength of the top cell 103c, the wavelength 650 nm corresponds to the maximum wavelength of the middle cell 103b, and the wavelength 750 nm corresponds to the maximum wavelength of the bottom cell 103a, respectively.

From the result of FIG. 8, it is understood that the increase in the transmittivity accompanied with the increase in the sheet resistance is remarkable as the wavelength becomes longer. This result corresponds to the result in the light collection efficiency measurement shown in FIG. 2, that is, the result that the improvement of the current of the bottom cell having the maximum wave length existing in the long wavelength band largely contributes to the improvement of the light collection efficiency.

In this way, by forming the ITO as the transparent electrode such that the transmittivity of light (750 nm in the present example) of the maximum absorption wavelength of a unit element (bottom cell in the present example) having the smallest current in the light collection efficiency measurement becomes 90% or more and 99.8% or less, and the sheet resistance is 120 Ω/□ or more and 220Ω/□ or less, the current of the bottom cell can be effectively improved, and the photoelectric conversion efficiency of the stacked photovoltaic element of the triple constitution can be largely improved.

(Example 2)

The transparent electrode (ITO) was formed by using the apparatus shown in FIG. 2 on the sample substrate of the double constitution shown in FIG. 4. In the present example also, similarly as in Example 1, the substrate temperature was set to 200°C, and the ITO targets having five different $SnO_2$ content of 0.5 wt%, 1 wt%, 3 wt%, 5 wt% and 10 wt% were used. At the film formation time of the ITO, the gases of argon, oxygen, and water vapor is used, and the feed rate of vapor was adjusted as a parameter for changing a sheet resistance.

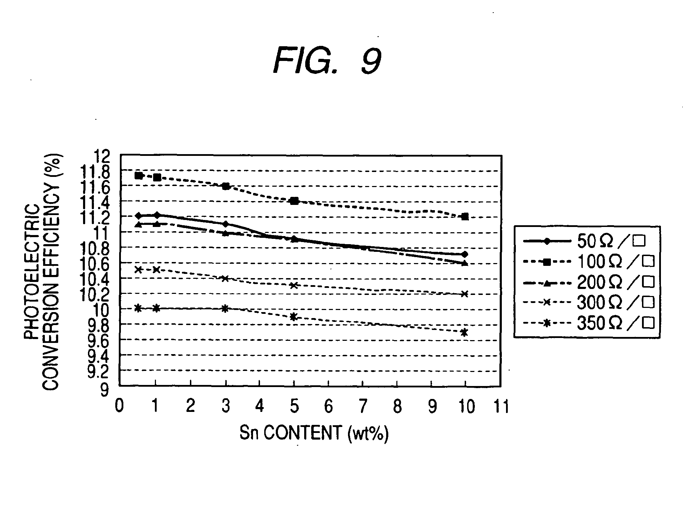

The initial characteristics of the photoelectric conversion efficiency of the stacked photovoltaic element produced as described above were estimated by using the solar simulator (AM 1.5, 100 mW/cm$^2$, and the surface temperature 25°C). The result is shown in FIG. 9. From FIG. 9, the suitable range of the sheet resistance of the transparent electrode used for the stacked photovoltaic element of a double constitution can be derived. To be more precise, it is understood that the range is preferably 120Ω/□ or more and 220Ω/□ or less.

Next, to estimate the absorption of the light by which the transparent electrode contributes to a collecting current, the current of each stacked semiconductor layer was estimated not by the Jsc itself, but by a light collection efficiency measurement (Q curve measurement). As a result, the stacked photovoltaic element of the double constitution of the present embodiment was 13 to 15 mA/cm$^2$ in current of the unit element, and the current of the unit element is larger than that of the triple constitution of Example 1.

In the stacked photovoltaic element of the double constitution produced in the present example, the unit element having the smallest current in the light collection efficiency measurement was the bottom cell (having the maximum absorption wavelength: 750 nm) in either case. Further, the increase in the current accompanied with the increase in the sheet resistance of the ITO was larger in the bottom cell than in the top cell (having the maximum absorption wavelength: 500 nm).

In this way, by forming the ITO as the transparent electrode such that the transmittivity of the light (750 nm) of the maximum absorption wavelength of a unit element (bottom cell) having the smallest current in the light collection efficiency measurement is 90% or more and 99.8% or less, and the sheet resistance is 120Ω/□ or more and 220Ω/□ or less, the current of the bottom cell can be effectively improved, and as a result, the photoelectric conversion efficiency of the stacked photovoltaic element of the double constitution can be largely improved.

As evident from the result of FIGS. 5 and 6 and FIG. 9, in the stacked photovoltaic element of the triple constitution and the double constitution, the optimum sheet resistance of the transparent electrode is different. In the case of the triple constitution, even if the sheet resistance of the transparent electrode is higher, the photoelectric conversion efficiency is improved, and it can be said that the influence of the sheet resistance on the photoelectric conversion efficiency is different in difference between the current of the triple constitution and the double constitution.

According to the present invention, by forming the ITO as the transparent electrode such that the transmittivity of the light of the maximum absorption wavelength of the unit element having the smallest current in the light collection efficiency measurement becomes 90% or more and 99.8% or less, and the sheet resistance becomes 120Ω/□ or less and 220Ω/□ or less, the stacked photovoltaic element excellent in the photoelectric conversion efficiency with high reliability can be realized at a low cost, thereby contributing to a fully-fledged popularization for use of the system power of the solar cell.

The stacked photovoltaic element of the present invention is a stacked photovoltaic element as recited in claim 1. Such a constitution of the present invention provides a stacked photovoltaic element having an excellent photoelectric conversion efficiency and high reliability at a low cost.

**Claims**

1. A stacked photovoltaic element comprising a stack formed of

   a plurality of unit elements (103a, 103b, 103c) each having a pin constitution, and
   a transparent electrode (104) provided on a surface of a light incident side of the stacked unit elements, wherein the transparent electrode (104) provided on the surface of the light incident side comprises indium tin oxide (ITO), and the transparent electrode has 90% or more and 99.8% or less in transmittivity of a light of the maximum absorption wavelength of a unit element having the smallest current in a light collection efficiency measurement among the plurality of unit elements, a film thickness of the transparent electrode is 60 nm or more and 70 nm or less,

   **characterized in that**
   the transparent electrode (104) has a sheet resistance of 120 Ω/□ or more and 220 Ω/□ or less in order to achieve an improved photoelectric conversion efficiency.

2. The stacked photovoltaic element according to claim 1, wherein a current value of the unit element having the smallest current in the light collection efficiency measurement is 12 mA/cm$^2$ or less.

3. The stacked photovoltaic element according to any one of claims 1 to 2, wherein the stacked photovoltaic element has a construction in which three unit elements each having a pin constitution are stacked.

4. The stacked photovoltaic element according to any one of claims 1 to 2, wherein the stacked photovoltaic element has a construction in which two unit elements each having a pin constitution are stacked.

5. The stacked photovoltaic element according to any one of claims 1 to 4, wherein the transparent electrode is formed by deposition using an indium tin oxide target having 0.5 wt% or more and 4 wt% or less of SnO$_2$ content.

6. A method of producing a stacked photovoltaic element, comprising the steps of

   stacking a plurality of unit elements each having a pin constitution and forming a transparent electrode on a surface of a light incident side of the stacked unit elements by sputtering using an indium tin oxide target having 0.5 wt% or more and 4 wt% or less of SnO2 content,
   **characterized in that**
   in the step of forming the transparent electrode, a water vapor amount in an atmosphere during sputtering is adjusted such that the transparent electrode has 90% or more and 99.8% or less in transmittivity of a light of the maximum absorption wavelength of a unit element having the smallest current in a light collection efficiency measurement among the plurality of unit elements and 120 Ω/□ or more and 220 Ω/□ or less in sheet resistance.

7. The method according to claim 6, wherein additionally the oxygen of a feed gas during sputtering is adjusted.

**Patentansprüche**

1. Ein gestapeltes photovoltaisches Element mit einem Stapel, der gebildet ist aus

   einer Vielzahl von Einheitselementen (103a, 103b, 103c), jeweils einen pin-Aufbau haben, und
   einer transparenten Elektrode (104), die auf einer Oberfläche einer Lichteinfallsseite der gestapelten Einheitselemente vorgesehen ist, wobei die transparente Elektrode (104), die auf der Oberfläche der Lichteinfallsseite vorgesehen ist, Indiumzinnoxyd (ITO) aufweist, und wobei die transparente Elektrode 90% oder mehr und 99.8% oder weniger in einer Transmittivität eines Lichts der maximalen Absorptionswellenlänge eines Einheitselements aufweist, das unter der Vielzahl von Einheitselementen den kleinsten Strom in einer Lichtsammeleffizienzmessung hat, eine Schichtdicke der transparenten Elektrode 60 nm oder mehr und 70 nm oder weniger ist,
   **dadurch gekennzeichnet, dass**
   die transparente Elektrode (104) einen Schichtwiderstand von 120 Ω/□ oder mehr und 220 Ω/□ oder weniger hat, um eine verbesserte photoelektrische Umwandlungseffizienz zu erreichen.

2. Gestapeltes photovoltaisches Element nach Anspruch 1, wobei ein Stromwert des Einheitselements mit dem kleinsten Strom in der Lichtsammeleffizienzmessung 12 mA/cm$^2$ oder weniger ist.

3. Gestapeltes photovoltaisches Element nach einem der Ansprüche 1 bis 2, wobei das gestapelte photovoltaische Element eine Konstruktion hat, in der drei Einheitselemente gestapelt sind, die jeweils einen pin-Aufbau haben.

4. Gestapeltes photovoltaisches Element nach einem der Ansprüche 1 bis 2, wobei das gestapelte photovoltaische Element eine Konstruktion hat, in der zwei Einheitselemente gestapelt sind, die jedes einen pin-Aufbau haben.

5. Gestapeltes photovoltaisches Element nach einem der Ansprüche 1 bis 4, wobei die transparente Elektrode durch Ablagern unter Verwendung eines Indiumzinnoxydtargets mit 0.5 Gew-% oder mehr und 4 Gew-% oder weniger eines SnO$_2$ Gehalts gebildet ist.

6. Verfahren zum Herstellen eines gestapelten photovoltaischen Elements mit den Schritten

   Stapeln einer Vielzahl von Einheitszellen, die jede einen pin-Aufbau haben, und Bilden einer transparenten Elektrode auf einer Oberfläche einer Lichteinfallsseite der gestapelten Einheitselemente durch Sputtern unter Verwendung eines Indiumzinnoxydtargets mit 0,5 Gew-% oder mehr und 4 Gew-% oder weniger eines SnO$_2$ Gehalts,
   **dadurch gekennzeichnet, dass**
   in dem Schritt des Bildens der transparenten Elektrode eine Wasserdampfmenge in einer Atmosphäre während des Sputterns so angepasst ist, dass die transparente Elektrode 90% oder mehr und 99.8% oder weniger in einer Transmittivität eines Lichts der maximalen Absorptionswellenlänge eines Einheitselements unter der Vielzahl von Einheitselementen mit dem kleinsten Strom in einer Lichtsammlungseffizienzmessung hat, und 120 Ω/□ oder mehr und 220 Ω/□ oder weniger in einem Schichtwiderstand hat.

7. Verfahren nach Anspruch 6, wobei zusätzlich der Sauerstoff eines Zuführgases während des Sputterns angepasst wird.

**Revendications**

1. Elément photovoltaïque empilé comprenant une pile formée :

   d'une pluralité d'éléments unitaires (103a, 103b, 103c) ayant chacun la structure d'une broche, et
   d'une électrode transparente (104) disposée sur une surface d'un côté d'incidence de la lumière des éléments unitaires empilés, dans lequel l'électrode transparente (104) disposée sur la surface du côté d'incidence de la lumière comprend de l'oxyde d'indium-étain (ITO), et l'électrode transparente a une transmissivité de 90 % ou plus et de 99,8 % ou moins vis-à-vis d'une lumière à la longueur d'onde d'absorption maximale d'un élément unitaire ayant le courant le plus faible lors d'une mesure du rendement de captation de la lumière parmi la pluralité d'éléments unitaires, l'épaisseur de film de l'électrode transparente étant de 60 nm ou plus et de 70 nm ou moins,

**caractérisé en ce que**

l'électrode transparente (104) a une résistance par carré de 120 Ω/□ ou plus et 220 Ω/□ ou moins afin d'obtenir un rendement de conversion photoélectrique amélioré.

2. Elément photovoltaïque empilé selon la revendication 1, dans lequel la valeur du courant de l'élément unitaire ayant le courant le plus faible lors d'une mesure du rendement de captation de la lumière est de 12 mA/cm$^2$ ou moins.

3. Elément photovoltaïque empilé selon l'une quelconque des revendications 1 et 2, dans lequel l'élément photovoltaïque empilé a une structure dans laquelle trois éléments unitaires ayant chacun la structure d'une broche sont empilés.

4. Elément photovoltaïque empilé selon l'une quelconque des revendications 1 et 2, dans lequel l'élément photovoltaïque empilé a une structure dans laquelle deux éléments unitaires ayant chacun la structure d'une broche sont empilés.

5. Elément photovoltaïque empilé selon l'une quelconque des revendications 1 à 4, dans lequel l'électrode transparente est formée par dépôt d'une cible d'oxyde d'indium-étain ayant une teneur en SnO$_2$ de 0,5 % en poids ou plus et de 4 % en poids ou moins.

6. Procédé de production d'un élément photovoltaïque empilé, comprenant les étapes consistant à :

empiler une pluralité d'éléments unitaires ayant chacun la structure d'une broche et former par pulvérisation cathodique une électrode transparente sur une surface d'un côté d'incidence de la lumière des éléments unitaires empilés en utilisant une cible d'oxyde d'indium-étain ayant une teneur en SnO$_2$ de 0,5 % en poids ou plus et de 4 % en poids ou moins,

**caractérisé en ce que**

lors de l'étape de formation de l'électrode transparente, la quantité de vapeur d'eau dans l'atmosphère pendant la pulvérisation cathodique est ajustée de façon que l'électrode transparente ait une transmissivité de 90 % ou plus et de 99,8 % ou moins pour une lumière à la longueur d'onde d'absorption maximale d'un élément unitaire ayant le courant le plus faible lors d'une mesure du rendement de captation de la lumière parmi la pluralité d'éléments unitaires, et une résistance par carré de 120 Ω/□ ou plus et de 220 Ω/□ ou moins.

7. Procédé selon la revendication 6, dans lequel on ajuste en outre l'oxygène d'un gaz d'alimentation pendant la pulvérisation cathodique.

## FIG. 1

## FIG. 2

# FIG. 3

# FIG. 4

## FIG. 5

## FIG. 6

## FIG. 7

Legend:
- ----◆---- TOP
- ----■---- MIDDLE
- ----▲---- BOTTOM
- --●-- PHOTOELECTRIC CONVERSION EFFICIENCY

## FIG. 8

Legend:
- ----◆---- TOP
- ----■---- MIDDLE
- ----▲---- BOTTOM

# FIG. 9

**EP 1 501 131 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001152323 A
- JP 2999280 B
- US 5279679 A
- EP 509215 B1
- US 5417770 A
- EP 0698929 A2
- JP 2002328999 A